# EUROPEAN PATENT APPLICATION

(11) **EP 4 016 651 A1**
(43) Date of publication of application: **22.06.2022**
(21) Application number: 20851720.1
(22) Date of filing: 28.06.2020
(51) Int. Cl.: H01L 33/62, H01L 25/075

(54) **LIGHT-EMITTING ENCAPSULATION ASSEMBLY, LIGHT-EMITTING MODULE AND DISPLAY SCREEN**

(30) Priority: 13.08.2019 CN 201921314132 U; 18.09.2019 CN 201921553485 U; 30.03.2020 CN 202010234735
(71) Applicant: Quanzhou Sanan Semiconductor Technology Co., Ltd., Quanzhou, Fujian 362343 (CN)
(72) Inventor: LIAO, Yanqiu, Xiamen, Fujian 361009 (CN); SHI, Junpeng, Xiamen, Fujian 361009 (CN); XIN, Shuning, Xiamen, Fujian 361009 (CN); HSU, Chen-ke, Xiamen, Fujian 361009 (CN); LIN, Zhen-duan, Xiamen, Fujian 361009 (CN); YU, Changchin, Xiamen, Fujian 361009 (CN); CAO, Aihua, Xiamen, Fujian 361009 (CN); LIAO, Chi-wei, Xiamen, Fujian 361009 (CN); WU, Zheng, Xiamen, Fujian 361009 (CN); LEE, Chia-en, Xiamen, Fujian 361009 (CN)
(74) Representative: Petraz, Gilberto Luigi
(86) International application number: PCT/CN2020/098499
(87) International publication number: WO 2021/027406

(57) **Abstract**

An LED encapsulation assembly, a light-emitting module and a display screen. The LED encapsulation assembly comprises: N light-emitting units arranged in an NX × NY matrix, wherein NX and NY are integers, NX ≥ NY, and N≥3; each of the light-emitting units comprises a LED chips (100); each LED chip (100) comprises a first electrode and a second electrode on the same side; an encapsulation layer (200) for filling gaps between the LED chips (100) and covering sidewalls of the LED chips (100); wiring layers (310-330) formed on a second surface of the plurality of LED chips (100) and used for electrically connecting the plurality of light-emitting units to form an N-in-one light-emitting module; and pads formed on the wiring layers (310-330), wherein the number of pads is P=Nx+Ny×a. According to the encapsulation assembly, the number of pads of the encapsulation assembly can be reduced to the greatest possible extent, thereby facilitating wiring, and being beneficial for a patch at an application end so as to reduce the risk of a short circuit.

## Description

The present application claims priority to China Utility Model Patent Application No. 201921314132.6, entitled "ALL-IN-ONE LIGHT-EMITTING MODULE AND DISPLAY", filed on August 13, 2019, China Utility Model Patent Application No. 201921553485.1, entitled "LIGHT-EMITTING DIODE PACKAGE ASSEMBLY", filed on September 18, 2019, and China Utility Model Patent Application No. 202010234735.6, entitled "AN N-IN-1 PACKAGE AND DISPLAY", filed on March 30, 2020. The entire contents of the above applications are incorporated by reference into the present application.

### TECHNICAL FIELD

The present invention relates to the field of display technology, and in particular to a light-emitting package assembly, a light-emitting module, and a display.

### BACKGROUD

In the large-size display market, small-pitch LED (light-emitting diode) display occupies an increasing market share. Small pitch LED display refers to indoor LED display with an LED dot pitch of P2.5 or below. With the improvement of LED display manufacturing technology, the resolution of conventional LED displays has been significantly improved.

Reducing the size of LED devices can enhance the resolution of the display screen, thus expanding the application areas of LED displays, such as cell phones, car panels, TVs, computers, video conferencing, etc. The current package sizes used in mainstream displays include 2121and 1010, and with the development of technology, 0808 and even smaller package sizes have appeared in the market. However, with reduction of the pixel pitch of LED display screen, the number of package devices per unit area is increasing, and the existing LED display screen mostly adopts the form of single package, which increases the difficulty of package exponentially. A small package device has three color chips, i.e., RGB (red, green, blue) and has four pins, and correspondingly the bottom of the substrate needs four pads, so the number of pads per unit area is too much, increasing the difficulty of packaging.

### SUMMARY

### TECHNICAL PROBLEM

### SOLUTION TO TECHNICAL PROBLEM

### TECHNICAL SOLUTION

One of the objects of the present invention is to provide an all-in-one light-emitting module, which can reduce the number of pads and reduce the difficulty of packaging.

The present invention provides an all-in-one light-emitting module including N light-emitting units, N being an integer greater than one, and a first electrode pads and b second electrode pads connected to the N light-emitting units. The first electrode pads and the second electrode pads are of opposite polarity. Each light-emitting unit includes n light-emitting chips, n being an integer greater than or equal to 3. Each light-emitting chip is connected to a first electrode pad and a second electrode pad, and different light-emitting chips are connected to different combinations of the first electrode pad and the second electrode pad. a×b is equal to n×N, wherein a and b are each an integer greater than or equal to one.

In an embodiment, the number of first electrode pads is the same as the number of the light-emitting units, and N common terminals of the N light-emitting units are connected to N first electrode pads in one to one correspondence.

In an embodiment, each light-emitting unit includes a red-light chip, a green-light chip and a blue-light chip. The red-light chips of all light-emitting units are connected to a first one of the second electrode pads; the green-light chips of all light-emitting units are connected to a second one of the second electrode pads, and the blue-light chips of all light-emitting units are connected to a third one of the second electrode pads.

In an embodiment, each light-emitting unit further includes a white light chip, and the white light chips of all light-emitting units are connected to a fourth one of the second electrode pads.

In an embodiment, the number of the light-emitting units is four, the number of the first electrode pads is four, and the common terminals of the four light-emitting units are connected to the four first electrode pads in one to one correspondence.

In an embodiment, the number of the light-emitting units is two, the number of the first electrode pads is two, and the common terminals of the two the light-emitting units are connected to the two first electrode pads in one to one correspondence.

In an embodiment, the number of the first electrode pad is one, N common terminals of the N light-emitting units are connected to the common first electrode pad. Each light-emitting chip is connected to a respective one of the second electrode pads, and the number of the second electrode pads is the product of n and N.

In an embodiment, each light-emitting unit includes three kinds of light-emitting chips which include a red-light chip, a green-light chip and a blue-light chip, and the number of the second electrode pads is 3×N.

In an embodiment, each light-emitting unit includes four kinds of light-emitting chips which include a red-light chip, a green-light chip, a blue-light chip and a white light chip, and the number of the second electrode pads is 4×N.

In an embodiment, the above-mentioned all-in-one light-emitting module further includes a light-shielding material wrapped around sides of the light-emitting chips and exposing electrodes of the light-emitting chips, and the light-shielding material and all light-emitting chips form a light-emitting layer of the light-emitting module.

In an embodiment, the above-mentioned all-in-one light-emitting module further includes a first circuit layer, a via circuit layer and a pad layer provided sequentially under the light-emitting layer. The first circuit layer includes a first insulating layer affixed to the light-emitting layer and a metal wiring layer embedded within the first insulating layer and connecting the electrodes of the light-emitting chip. The via circuit layer includes a second insulating layer affixed to the first insulating layer and having vias, a pad lead layer provided within the vias and connecting the metal wiring layer. The pad layer is provided with the first electrode pads and the second electrode pads, and the first electrode pads and the second electrode pads are connected to the metal wiring layer via the pad lead layer.

In an embodiment, the pad layer further includes electrode wires connecting the pad lead layer to the first electrode pads, or connecting the pad lead layer to the second electrode pads.

In an embodiment, the pad layer further includes a third insulating layer filled around the first electrode pads, the second electrode pads and the electrode wires.

In an embodiment, the first insulating layer, the second insulating layer or the third insulating layer is of black insulating material.

Another aspect of the present application provides a display which is formed by splicing a plurality of any of the all-in-one light-emitting modules as described above.

The present application also provides an all-in-one light-emitting module including N light-emitting units, a first electrode pads and b second electrode pads. Each light-emitting unit includes n light-emitting chips each connected to a first electrode pad and a second electrode pad. Different light-emitting chips are connected to different combinations of the first electrode pad and second electrode pad. The relation a×b = n×N is met. Therefore, the total number of pads can be a+b, while the number of pads of an existing all-in-one light-emitting module is (n+1)×N. The all-in-one light-emitting module of the present application reduces the number of pads and the difficulty of packaging.

Another object of the present invention is to provide an ultra-small pitch light-emitting diode (LED) package assembly including a plurality of pixel regions PX arranged in an Nx×Ny matrix. Each pixel region PX may be referred to as a pixel.

In some embodiments, the LED package assembly includes N light-emitting units arranged in a Nx×Ny matrix, wherein Nx and Ny are integers, Nx≥Ny, and N≥3, each light-emitting unit including a LED chips each including a first electrode and a second electrode located on a same side; an packaging layer filling gaps between the LED chips and covering side walls of the LED chips; a wiring layer, formed on a second surface of the plurality of LED chips and electrically connecting the plurality of light-emitting units to form an N-in-one light-emitting module; and pads, formed on the wiring layer, the number of the pads P being equal to Nx+Ny×a.

Preferably, the N light-emitting units are arranged in Nx rows and Ny columns, which makes sure that the number P of the pads is minimal.

In some embodiments, the a LED chips of each light-emitting unit are arranged in a column in a first direction Nx, and the first electrode and the second electrode of each LED chip are arranged side by side in a second direction Ny.

In some embodiments, N is equal to 2^{2×k}, and Nx:Ny is equal to 4:1, where k is a natural number.

In some embodiments, N is equal to 3^{2×k+1}, and Nx:Ny is equal to 3:1, where k is an integer greater than or equal to zero.

Preferably, a pitch D1 between adjacent light-emitting units is 0.8 mm or less. N is an integer greater than or equal to 4, such as 4, 6, 8, 9, 16, 32 or 64, etc. The larger the value of N, the smaller the value of D1 is. For example, when N is 4-9, D1 can be 0.4-0.8, and when N is 8 or more, then D can be 0.1-0.4.

In some embodiments, a first wiring layer electrically connects the first electrodes of the LED chips of same type located in the same row from the first direction, and electrically connects the second electrodes of the LED chips located in the same column from the second direction Ny.

In some embodiments, the wiring layer includes a first wiring layer, a via layer and a second wiring layer. The first wiring layer is formed on the second surface of the plurality of LED chips and connected to the first electrodes and second electrodes of the plurality of LED chips. The via layer is formed on the first wiring layer and is electrically connected to the first wiring layer, and the second wiring layer formed on the via layer and is electrically connected to the via layer. Preferably, the via layer has a thickness of 20~80 µm.

Preferably, the package assembly has a total thickness of 100 µm to 500 µm. In some embodiments, the package assembly has a total thickness of 120 µm to 200 µm. In some embodiments, the package assembly has a total thickness of 320 µm to 500 µm.

Preferably, the wiring layer includes multiple layers of conductive wires electrically isolated from each other. The number of layers of the conductive wires is four or less. In some embodiments, at least one layer of the multiple layers of the conductive wires has a thickness of 50 µm or less. In some embodiments, at least one layer of the multiple layers of the conductive wires has a thickness of 60 µm or less.

The function and effect of the above embodiment include that the embodiment adopts the form of packaging without substrate, in which the LED chips of multiple light-emitting units are fixed by a packaging layer, and the LED chips of the multiple light-emitting units are connected in series or in parallel by forming a multi-layer wiring layer on the back of the multi-layer light-emitting units. The first wiring layer connects the LED chips of multiple pixel regions in series and parallel, and through the via layer and the second wiring layer, rewiring is carried out to form an integrated thin and small-pitch light-emitting diode package assembly. In addition, by a reasonable wiring layer, on the one hand, it can reduce the number of pads of the package assembly for external connection, reducing the difficulty of placement of chips at the application end, while improving the reliability of the product. Further, the number of layers of the wiring layer is no more than four, which ensures that the product is thin and light, facilitating thin and light design of the end products.

Yet another object of the present invention is to provide an N-in-1 package with excellent heat dissipation performance, less susceptible to short circuiting, and conducive to placement of chips at the application end.

To achieve the above and other objects, the present invention provides an N-in-one package including: N light-emitting units, N being an integer greater than one and less than or equal to 64, sqrt(N) being an integer greater than one, the number of the light-emitting units being equal to sqrt(N) in any of the length direction and width direction of the package, each light-emitting unit including one red-light chip, one blue-light chip and one green-light chip, defining a pitch between any two adjacent the chips of the same wavelength as X, the length and width of the package are both equal to X^{∗}sqrt (N); and electrode pads, electrically connected to the N light-emitting units. The total number of electrode pads is within the range of a rounded-up integer of 2^{∗}sqrt (3N)±1. In any one of the length direction and width direction of the outmost of the package, the number of electrode pads is within the range of a rounded-up integer of sqrt [2^{∗}sqrt (3N)] to a rounded-down integer of sqrt [2^{∗}sqrt (3N)]. In at least one of the length direction and width direction of the outmost of the package, the number of electrode pads is equal to a rounded-up integer of sqrt [2^{∗}sqrt (3N)], and in the direction that the number of electrode pads is equal to a rounded-up integer of sqrt [2^{∗}sqrt (3N)], the sizes of the electrode pads are equal to the spacing between two adjacent electrode pads. Defining the length and the width of the electrode pads as Y, the length and width of the package are both approximately equal to 2^{∗}sqrt [2^{∗}sqrt(3N)]^{∗}Y, so the package meets the relation X≥{0.2^{∗}sqrt[2^{∗}sqrt(3N)]}/sqrt(N).

In an embodiment, the electrode pads have equal length and width, both greater than or equal to 0.1 mm.

In an embodiment, the spacing between two adjacent the electrode pads is greater than or equal to 0.1 mm in either of the length direction and width direction of the package.

In an embodiment, when the number of the electrode pads in both the length direction and the width direction of the outermost of the package is equal to rounded-up integer of sqrt [2^{∗}sqrt(3N)], the spacing of two adjacent the electrode pads in the length direction of the outermost of the package is equal to the spacing of two adjacent the electrode pads in the width direction of the outermost of the package.

In an embodiment, when the number of the electrode pads in the length direction and in the width direction of the outermost of the package are equal to a rounded-up integer and a rounded-down integer of sqrt [2^{∗}sqrt(3N)], respectively, the spacing between two adjacent the electrode pads in the direction that the number of electrode pads is equal to a rounded-down integer of sqrt [2^{∗}sqrt(3N)] is greater than the spacing between two adjacent the electrode pads in the direction that the number of electrode pads is equal to a rounded-up integer of sqrt [2^{∗}sqrt(3N)].

In an embodiment, the length and the width of the package are equal.

In an embodiment, the number of the light-emitting units in the length direction of the package is equal to the number of the light-emitting units in the width direction of the package.

In an embodiment, the electrode pads include first electrode pads and second electrode pads. Each chip of each the light-emitting unit is electrically connected to one the first electrode pad and one the second electrode pad, and the chips of different wavelengths are electrically connected to different combinations of the first electrode pads and the second electrode pads.

In an embodiment, the number of the first electrode pads is the same as the number of the light-emitting units, and the N common terminals of the N light-emitting units are electrically connected to N first electrode pads in one to one correspondence.

The present invention also provides a display including a plurality of N-in-one packages as described above.

In an embodiment of the present invention, the display has a ratio of diagonal, length and width of 18.36:16:9.

### EFFECTS OF THE INVENTION EFFECTS

As previously described, the N-in-one package provided by the present invention includes N light-emitting units and electrode pads electrically connected thereto. Each the light-emitting unit includes a red-light chip, a blue-light chip and a green-light chip. The pitch X between any two adjacent chips of the same wavelength and the number N of the light-emitting units meet the relation X≥{0.2^{∗}sqrt[2^{∗}sqrt(3N)]}/sqrt(N). According to the N-in-one package of the present invention, on the basis of meeting the above relation, the most suitable number N of the light-emitting units can be selected when any two adjacent the chips of the same wavelength have a certain pitch X therebetween, so as to ensure that the length and width of the electrode pads of the package are greater than or equal to 0.1mm, which can meet the high-density demand of the small-pitch LED package and also provide the package with sufficient heat dissipation capacity, thereby effectively guaranteeing the reliability of the product, effectively avoiding the risk of short circuit, and facilitating the placement of chip at the application end.

### BRIEF DESCRIPTION OF THE DRAWINGS

### DESCRIPTION OF THE DRAWINGS

In order to more clearly illustrate the technical solutions of the embodiments of the present application, the accompanying drawings used in the description of the embodiments of the present application will be briefly described below.
FIG. 1 is a schematic diagram of a circuit of a sixteen-in-one light-emitting module of an embodiment of the present application.
FIG. 2 is a schematic diagram of a circuit of a four-in-one light-emitting module of an embodiment of the present application.
FIG. 3 is a schematic diagram of a circuit of a two-in-one light-emitting module of an embodiment of the present application.
FIG. 4 is a schematic diagram of a circuit of a four-in-one light-emitting module of another embodiment of the present application.
FIG. 5 is a schematic sectional diagram of an all-in-one light-emitting module of an embodiment of the present application.
FIG. 6 is a schematic diagram showing wiring of a first circuit layer of a four-in-one light-emitting module of an embodiment of the present application.
FIG. 7 is a schematic diagram of a via circuit layer of the four-in-one light-emitting module of the embodiment in FIG. 6.
FIG. 8 is a schematic diagram of a pad layer of the four-in-one light-emitting module of the embodiment in FIG. 6.
FIG. 9 is a schematic diagram of a lamination of the first circuit layer, via circuit layer and pad layer in FIGS. 6-FIG. 8.
FIG. 10 is a schematic diagram showing wiring of a first circuit layer of a four-in-one light-emitting module of another embodiment of the present application.
FIG. 11 is a schematic diagram of a via circuit layer of the four-in-one light-emitting module of the embodiment in FIG. 10.
FIG. 12 is a schematic diagram of a pad layer of the four-in-one light-emitting module of the embodiment in FIG. 10.
FIG. 13 is a schematic diagram of a lamination of the first circuit layer, via circuit layer and pad layer in FIG. 10-FIG. 12.
FIG. 14 is a schematic diagram showing wiring of a first circuit layer of a two-in-one light-emitting module of an embodiment of the present application.
FIG. 15 is a schematic diagram of a via circuit layer of the two-in-one light-emitting module of the embodiment in FIG. 14.
FIG. 16 is a schematic diagram of a pad layer of the two-in-one light-emitting module of the embodiment in FIG. 14.
FIG. 17 is a schematic diagram of a lamination of the first circuit layer, the via circuit layer and the pad layer in FIG. 14-FIG. 16.
FIG. 18 is a perspective diagram illustrating a structure of the light-emitting diode (LED) package assembly of the present invention.
FIG. 19 is a top-view schematic diagram illustrating an arrangement of a LED chip of a LED package assembly of an embodiment of the present invention.
FIG. 20 is a side sectional schematic diagram illustrating a LED chip of the LED package assembly of the embodiment as a conventional LED chip.
FIG. 21 is a side sectional schematic diagram illustrating a structure of a LED package assembly of an embodiment of the present invention.
FIG. 22 is a top-view schematic diagram illustrating a first wiring layer of the LED package assembly of the embodiment.
FIG. 23 is a top-view schematic diagram illustrating a via layer of the light-emitting diode package assembly of the present invention.
FIG. 24 is a top-view schematic diagram illustrating a second wiring layer of the LED package assembly of the embodiment.
FIG. 25 is a wiring connection diagram illustrating the circuit connections of the LED package assembly of the embodiment.
FIG. 26 is a top-view schematic diagram illustrating an arrangement of LED chips the LED package assembly of an embodiment of the present invention.
FIG. 27 is a wiring connection diagram illustrating circuit connection of the LED package assembly of the embodiment.
FIGS. 28 and 29 are schematic diagrams of a structure of an N-in-1 package of an embodiment of the present invention.

### EMBODIMENTS OF THE INVENTION

### IMPLEMENTATIONS OF THE INVENTION

The technical solutions in embodiments of the present application will be described below in conjunction with the accompanying drawings in the embodiments of the present application.

Similar symbols and letters indicate similar items in the accompanying drawings below, so once an item is defined in one accompanying drawing, it does not need to be further defined and explained in subsequent accompanying drawings. Also, in the description of the present application, the terms "first", "second", etc. are used to distinguish the description only and are not to be construed as indicating or implying relative importance.

The present application provides an all-in-one light-emitting module. An all-in-one light-emitting module is one in which a plurality of light-emitting units are integrated on a single package module. A light-emitting unit may be equivalent to a small package containing three kinds of chips, RGB (red, green, and blue). An LED display can be formed by splicing a plurality of light-emitting modules, thus effectively solving the problem of low efficiency of a single package. An all-in-one light-emitting module can be, for example, a two-in-one, four-in-one, six-in-one, or N-in-one light-emitting module. N-in-one means that N light-emitting units are integrated on a single package module.

The present application provides an all-in-one light-emitting module, including N light-emitting units (N is an integer greater than one), a first electrode pads and b second electrode pads. a first electrode pads and b second electrode pads are connected to the N light-emitting units. The first electrode pads and the second electrode pads are of opposite polarity. The first electrode may be an anode and the second electrode is a cathode. The first electrode may be a cathode and the second electrode is an anode.

Each light-emitting unit includes n light-emitting chips, where n is an integer greater than or equal to three. Each light-emitting chip is connected to a first electrode pad and a second electrode pad. Different light-emitting chips are connected to different combinations of the first electrode pad and the second electrode pad. The relation a×b=n×N is met, where a and b are each an integer greater than or equal to one. As there are a first electrode pads and b second electrode pads, the number of electrode pads P can be a+b. To minimize the number of pads, the total number of pads can be taken as the minimum of a+b.

Different light-emitting chips are connected to different combinations of first electrode pad and second electrode pad, which means that there are not any two light-emitting chips connected to the same first electrode pad and second electrode pad, so that the light-emitting chips can be controlled independently.

A light-emitting chip needs to be connected to an anode pad and a cathode pad in order to emit light. So when there are a anode pads and b cathode pads, it can be considered to be able to connect a×b chips. Based on this principle, when there are a total of n×N light-emitting chips for a N-in-one light-emitting module in which each light-emitting unit includes n light-emitting chips, it is understandable that there should be a anode pads and b cathode pads (or a cathode pads and b anode pads) to meet a×b=n×N, in order to complete the connection of all light-emitting chips. Therefore, the number P of pads of the N-in-one light-emitting module may be a+b.

Taking the example of a four-in-one light-emitting module which includes four light-emitting units (i.e., N=4), and assuming that each light-emitting unit includes three RGB light-emitting chips (i.e., n=3), a four-in-one light-emitting module should have required 16 electrode pads. The present application provides a four-in-one light-emitting module including a first electrode pads and b second electrode pads, where a×b=n×N=12, so a and b may be respectively 1 and 12, 3 and 4, or 2 and 6. The total number of pads may be 13 (i.e., 1+12), 7 (i.e., 3+4) or 8 (i.e., 2+6).

Assuming a light-emitting unit includes three kinds of light-emitting chips, i.e. RGB, for a two-in-one light-emitting module for example, the number of light-emitting chips is 3×2=6, which only requires that the product (a×b) of the number a of the first electrode pads and the number b of the second electrode pads is equal to 6. Thus, a and b may be respectively 1 and 6, or 2 and 3. That is, the total number of pads may be 7 or 5. To minimize the number of pads, the number of pads of the two-in-one light-emitting module can be 5. A two-in-one light module should have required 8 electrode pads, but the present application provides a two-in-one light module that is able to reduce the number of pads to 7 or 5.

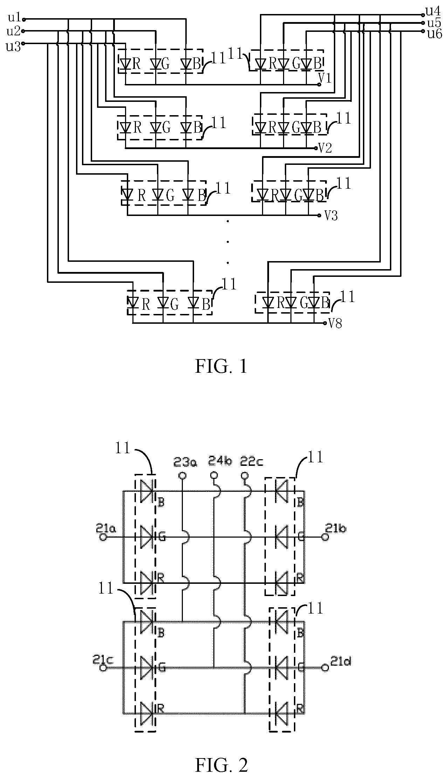

Assuming a light-emitting unit includes three kinds of light-emitting chips, i.e., RGB, for a sixteen-in-one light-emitting module for example, as shown in FIG. 1, there are 16 light-emitting units 11, and the number of light-emitting chips is 3×16=48, which only requires that the product (a×b) of the number a of the first electrode pads and the number b of the second electrode pads is equal to 48. Thus, the combination of a and b may be 1 and 48, 2 and 24, 3 and 16, 4 and 12, or 6 and 8. That is, the total number of pads can be 49, 26, 19, 16 or 14.

To minimize the number of pads, as shown in FIG. 1, the number of pads of the sixteen-in-one light-emitting module may be 14. V1-V8 designate 8 first electrode pads, u1-u6 designate 6 second electrode pads. A sixteen-in-one light-emitting module should have required 64 (4×16) electrode pads, but the application provides a sixteen-in-one light-emitting module that can reduce the number of pads to a minimum of 14.

In an embodiment, the number of first electrode pads is same as the number of light-emitting units. N common terminals of the N light-emitting units are connected to the N first electrode pads in one to one correspondence.

A light-emitting unit has a common terminal, which may be a common anode or a common cathode. A common anode or common cathode of a light-emitting unit can be connected to a first electrode pad. For a N-in-one light-emitting module, there are N light-emitting units, so that the common terminals of the N light-emitting units are connected to N first electrode pads in one to one correspondence. For example, a four-in-one light-emitting module has four light-emitting units, so there are four first electrode pads. A common anode of a light-emitting unit is connected to a first electrode pad, and in this case the first electrode may be referred to the anode. On the contrary, when a common cathode of each light-emitting unit is connected to the first electrode pad in one to one correspondence, the first electrode can be then the cathode.

When the number a of first electrode pads is the same as the number of light-emitting units N (i.e., a=N), according to a×b=n×N, the number b of second electrode pads is the same as the number n of light-emitting chips contained in each light-emitting unit. The number of pads can thus be reduced.

In an embodiment, each light-emitting unit may include three kinds of light-emitting chips, i.e., a red-light chip, a green-light chip, and a blue-light chip. In this case, the number of the second electrode pads may be three. The red-light chips of all light-emitting units are connected to the first second electrode pad. The green-light chips of all light-emitting units are connected to the second second electrode pad. The blue-light chips of all light-emitting units are connected to the third second electrode pad. As a result, the total number of first electrode pads and second electrode pads is reduced.

On the basis of the above embodiment, each light-emitting unit also includes a white light chip. The white light chips of all light-emitting units are connected to the fourth second electrode pad. In other words, each light-emitting unit includes four kinds of light-emitting chips, i.e., a red-light chip, a green-light chip, a blue-light chip and a white light chip. In this case, the number of the second electrode pads may be four, the light-emitting chips of the same color are connected to the same second electrode pad. Thus, even if a white-light chip is added to each light-emitting unit, the all-in-one light-emitting module only needs to add an electrode pad, reducing the number of pads.

In an embodiment, the all-in-one light-emitting module provided in the present application may be a four-in-one light-emitting module, the number of which is four. The number of first electrode pads is four. The common terminals of the four light-emitting units are connected to the four first electrode pads in one to one correspondence. The first electrode pads may be anode pads or cathode pads. The common anode or common cathode of each light-emitting unit is connected to one first electrode pad. In this case, the red-light chips of all light-emitting units can be connected to the first second electrode pad, the green-light chips of all light-emitting units are connected to the second second electrode pad, and the blue-light chips of all light-emitting units are connected to the third second electrode pad. If there are white-light chips, the white-light chips of all light-emitting units are connected to the fourth second electrode pad. As a result, the number of pads can be reduced to seven when three kinds of light-emitting chips exist in the four-in-one light-emitting module, reducing the number of pads in the four-in-one light-emitting module and reducing the difficulty of packaging.

FIG. 2 is a schematic diagram showing circuit connection of a four-in-one light-emitting module. As shown in FIG. 2, the four-in-one light-emitting module includes four light-emitting units 11, and the total number of pads can be seven. 21a, 21b, 21c, 21d designate the first electrode pads, and 23a, 24b, 22c designate the second electrode pads. The first electrode pads are connected to the anode, and the second electrode pads connected to the cathode, thus reducing the number of pads as much as possible to reduce the difficulty of packaging.

In an embodiment, the all-in-one light-emitting module provided in the present application may be a two-in-one light-emitting module, and the number of light-emitting units is two. The number of first electrode pads is two. The common terminals of the two light-emitting units are connected to the two first electrode pads in one to one correspondence. The first electrode pads may be anode pads or cathode pads. The common anode or common cathode of each light-emitting unit is connected to one first electrode pad. In this case, the red-light chips of all light-emitting units can be connected to the first second electrode pad, the green-light chips of all light-emitting units are connected to the second second electrode pad, and the blue-light chips of all light-emitting units are connected to the third second electrode pad. If there are also white-light chips, the white-light chips of all light-emitting units are connected to the fourth second electrode pad. As a result, the number of pads can be reduced to five when three kinds of light-emitting chips exist in the two-in-one light-emitting module, reducing the number of pads in the two-in-one light-emitting module and reducing the difficulty of packaging.

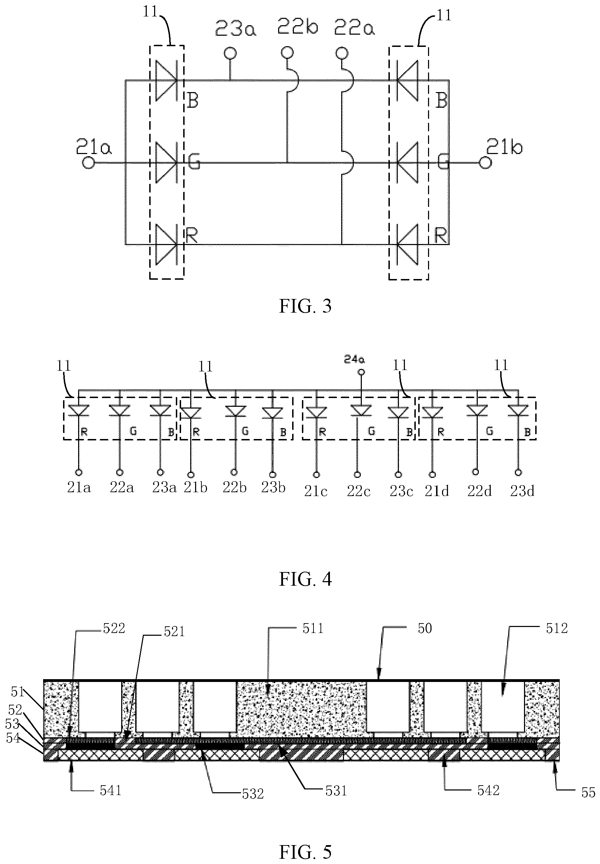

FIG. 3 is a schematic diagram showing circuit connection of a two-in-one light-emitting module. As shown in FIG. 3, the two-in-one light-emitting module includes two light-emitting units 11, and the total number of pads can be five. 21a, 21b designate the first electrode pads, and 22a, 22b, 23a designate the second electrode pads. The first electrode pads are connected to the anode, and the second electrode pads connected to the cathode.

In another embodiment, regardless of the number of light-emitting units or the number of light-emitting chips, the number of first electrode pads can always be one. N common terminals of N light-emitting units are connected to the same first electrode pad. Each light-emitting chip is individually connected to one second electrode pad. The number of second electrode pads is n×N, where n represents the number of light-emitting chips included in a light-emitting unit. N light-emitting units include a total of n×N light-emitting chips each connected to a second electrode pad, so n×N second electrode pads are needed. Thus, the total number of pads is n×N+1. However, a light-emitting unit of prior art requires n+1 pads, and the N light-emitting units require N(n+1) pads, so the solution of the present application can reduce the number of pads.

In an embodiment, each light-emitting unit includes three kinds of light-emitting chips, i.e., red-light chip, green-light chip and blue-light chip. That is, n=3, and the number of the second electrode pads is 3×N.

In an embodiment, each light-emitting unit includes four kinds of light-emitting chips, i.e., red-light chip, green-light chip, blue-light chip and white-light chips. That is, n=4, and the number of second electrode pads is 4×N.

FIG. 4 is a schematic diagram showing circuit connection of another four-in-one light-emitting module. As shown in FIG. 4, the four-in-one light-emitting module includes four light-emitting units 11, and each light-emitting unit includes three light-emitting chips, i.e., RGB. The total number of pads may be 13. 24a designates the first electrode pad, and 23d, 22d, 21d, 23c, 22c, 21c, 23b, 22b, 21b, 23a, 22a, 21a designate the second electrode pads. The first electrode pad is connected to anode and the second electrode pads are connected to the cathode.

FIG. 5 is a schematic sectional diagram of an all-in-one light-emitting module. As shown in FIG. 5, the all-in-one light-emitting module includes shielding material 511. The shielding material 511 wraps sides of the light-emitting chips 512 and exposes the electrodes of the light-emitting chips 512. Shielding material 511 and all light-emitting chips 512 constitute a light-emitting layer 51 of the light-emitting module. The shielding material 511 may be black colloid, and the shielding material 511 wraps the sides of the light-emitting chips 512 so as to absorb the light from the sides of the light-emitting chips 512, which improves the contrast of the display.

As shown in FIG. 5, the all-in-one light-emitting module also includes a first circuit layer 52, a via circuit layer 53 and a pad layer 54 provided in sequence under the light-emitting layer 51. The top of the light-emitting layer 51 can be covered with transparent colloid 50, allowing for better light emitting, while protecting the light-emitting chip 512. The light-emitting chip 512 can be a flip-chip one.

The first circuit layer 52 includes a first insulating layer 521 and a metal wiring layer 522. The first insulating layer 521 is affixed to the lower surface of the light-emitting layer 51. The metal wiring layer 522 is embedded in the first insulating layer 521 and connected to the electrodes of the light-emitting chips 512.

The via circuit layer 53 includes a second insulating layer 531 and a pad lead layer 532. The second insulating layer 531 is affixed to the lower surface of the first insulating layer 521. The second insulating layer 531 has vias, and the pad lead layer 532 is provided within the vias and is connected to the metal wiring layer 522.

The pad layer 54 includes the first electrode pads and the second electrode pads (collectively called pads 541), and the first electrode pads and the second electrode pads are connected to the metal wiring layer 522 through the pad lead layer 532.

At the metal wiring layer 522, electrodes that need to be connected to the same pad 541 can be connected together by circuit wires, and then connected to the corresponding pad 541 through the pad lead layer 532 in the vias. The first insulating layer 521 and the second insulating layer 531 may prevent short circuits between the lines.

In an embodiment, the pad layer 54 may further include electrode wires (not shown in the figures). The electrode wires connect the pad lead layer 532 to the first electrode pads, or to the second electrode pads. In addition to being connected together at the metal wiring layer 522, the electrodes that need to be connected to the same pad 541 can also be connected together at the pad layer 54 through the electrode wires, and then connected to the same pad 541. For the electrodes of the light-emitting chip that need to be connected to the same pad 541 may be first connected to the pad layer 54 through the pad lead layer 532, and then connected to corresponding pad 541 through the electrode wires of the pad layer 54 to establish conductive connection. The pad 541 can be the first electrode pad or the second electrode pad.

In an embodiment, as shown in FIG. 5, the pad layer 54 may also include a third insulating layer 542 that fills around the first electrode pad, the second electrode pad, and the electrode wires. Filling the insulating material around the electrode pads and electrode wires may prevent short circuits.

The first insulating layer 521, the second insulating layer 531, or the third insulating layer 542 described above may be a black insulating material, thereby absorbing back light, preventing light leakage and improving the contrast of the display. The underside of the solder pad layer 54 may also be covered with an ink layer 55, which covers the area other than the pad 541, thereby covering the electrode wires of the pad layer 54, which can prevent short circuits.

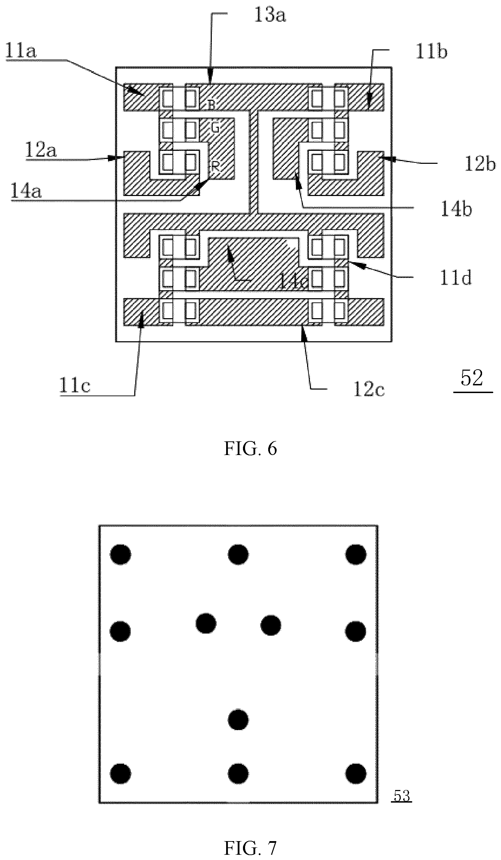

FIG. 6 is a schematic diagram showing wiring of the first circuit layer 52 of the four-in-one light-emitting module provided in an embodiment of the present application. As shown in FIG. 6, the four-in-one light-emitting module includes four light-emitting units each including three light-emitting chips, i.e., RGB, and there is a total of twelve light-emitting chips 512. The first circuit layer 52 has four common terminals (11a, 11b, 11c, 11d), a metal wire (13a) for four blue-light chips, metal wires (14a, 14b, 14c) for four green-light chips, and metal wires (12a, 12b, 12c) for four red-light chips. FIG. 7 is a schematic diagram of the via circuit layer 53 of the four-in-one light-emitting module in the embodiment of FIG. 6. The black dots represent the pad leads in the vias, surrounded by insulating material.

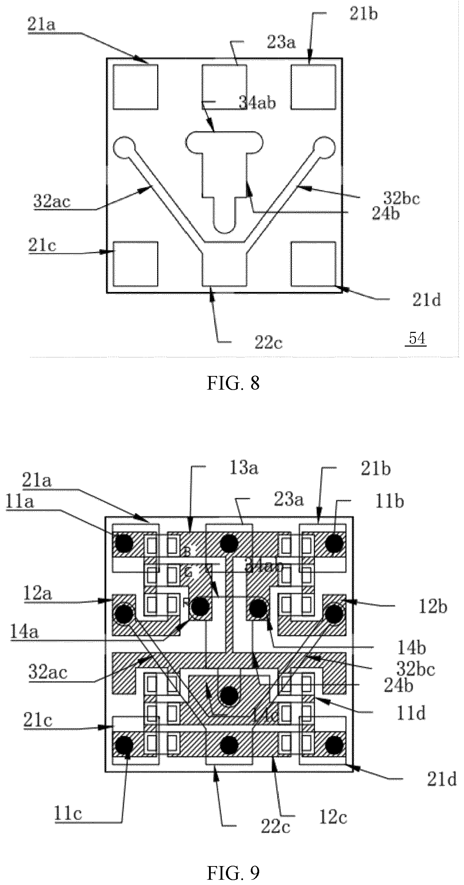

FIG. 8 is a schematic diagram of the pad layer 54 of the four-in-one light-emitting module in the embodiment of FIG. 6. As shown in FIG. 8, the four-in-one light-emitting module includes seven pads (21a, 21b, 21c, 21d, 23a, 24b, 22c), the electrodes of four green-light chips are connected together in this layer by an electrode wire (34ab) to the same pad (24b). The electrodes of four red-light chips are connected together in this layer by electrode wires (32ac and 32bc) to the same pad (22c). The electrodes of the four blue-light chips are connected together in the first circuit layer 52 and led out by the same pad (23a). The four common terminals (11a, 11b, 11c, 11d) of the first circuit layer 52 are connected to the four pads (21a, 21b, 21c, 21d) in one to one correspondence.

FIG. 9 is a schematic diagram of a lamination of the first circuit layer 52, the via circuit layer 53, and the pad layer 54 in FIGS. 6-8. As shown in FIG. 9, the common terminals (11a, 11b, 11c, 11d) of the first circuit layer 52 can be connected to the four pads (21a, 21b, 21c, 21d) of the pad layer through the pad leads of the via circuit layer 53, and the metal wires (13a) for the four blue-light chips are connected to the pads (23a) of the pad layer 54 through the pad leads of the via circuit layer 53. The metal wires (14a, 14b, 14c) for four green-light chips are connected to the electrode wire (34ab) of the pad layer 54 through the pad leads of the via circuit layer 53, and thus the four green-light chips are connected together and lead out through one pad (24b). The metal wires (12a, 12b, 12c) for the four red-light chips are connected together by the pad leads of via circuit layer 53 and the electrode wires (32ac, 32bc) of pad layer 54, and connected to the same pad (22c). The circuit principle of this four-in-one light-emitting module can be referred to FIG. 2.

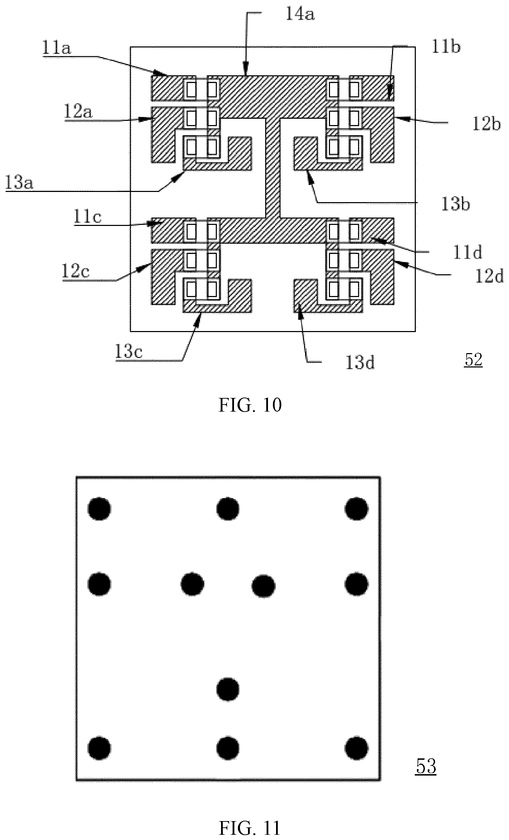

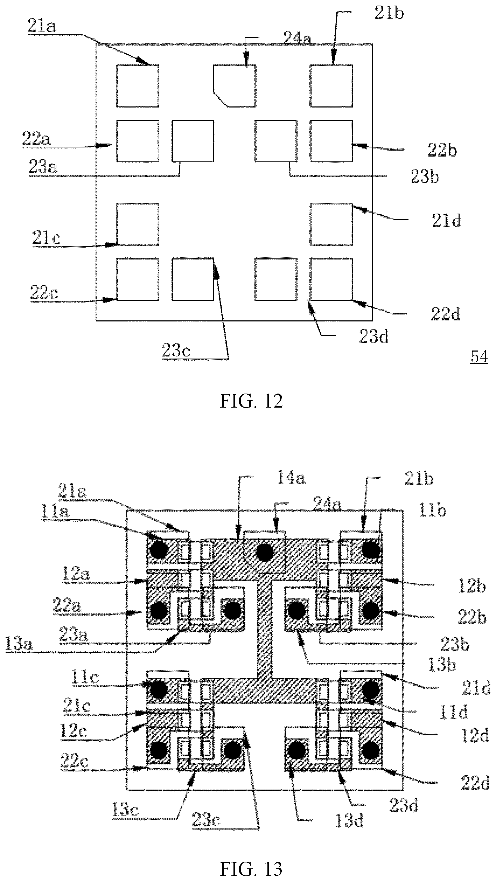

FIG. 10 is a schematic diagram showing wiring of the first circuit layer 52 of a four-in-one light-emitting module of another embodiment of the present application. Unlike FIG. 6, the first circuit layer 52 includes one common terminal (14a) and individual metal wires for the 12 light-emitting chips (11a, 12a, 13a; 11b, 12b, 13b; 11c, 12c, 13c; 11d, 12d, 13d). The common terminal may be a common anode or common cathode. A common terminal connects common electrodes of all light-emitting units. FIG. 11 is the via circuit layer 53 of the four-in-one light-emitting module in the embodiment of FIG. 10, with black dots representing the pad leads in the vias surrounded by insulating material. FIG. 12 is a schematic diagram of the pad layer 54 of the four-in-one light-emitting module in the embodiment of FIG. 10, which has a total of 13 pads (24a, 21a, 22a, 23a; 21b, 22b, 23b; 21c, 22c, 23c; 21d, 22d, 23d).

FIG. 13 is a schematic diagram of a lamination of the first circuit layer 52, the via circuit layer 53, and the pad layer 54 in FIGS. 10-FIG. 12. The common terminal (14a) of the first circuit layer 52 is connected to the pad (24a) through the pad leads of the via circuit layer 53. The individual metal wires (11a, 12a, 13a; 11b, 12b, 13b; 11c, 12c, 13c; 11d, 12d, 13d) of the 12 light-emitting chips in the first circuit layer 52 are connected to the pads (21a, 22a, 23a; 21b, 22b, 23b; 21c, 22c, 23c) in one to one correspondence through the pad leads of the via circuit layer 53. The circuit principle of this four-in-one light-emitting module can be referred to FIG. 4.

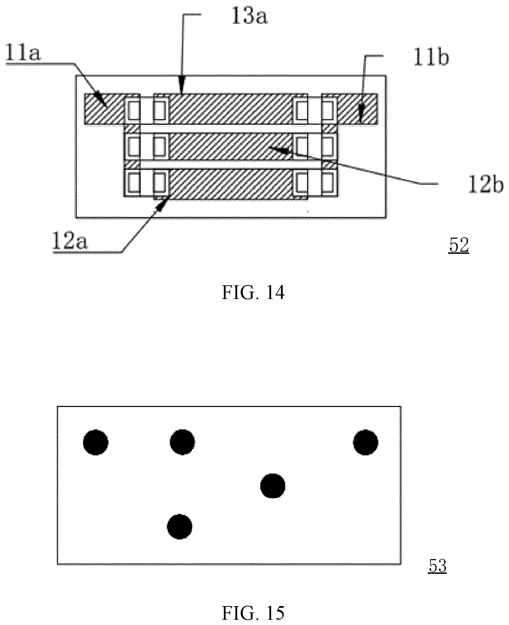

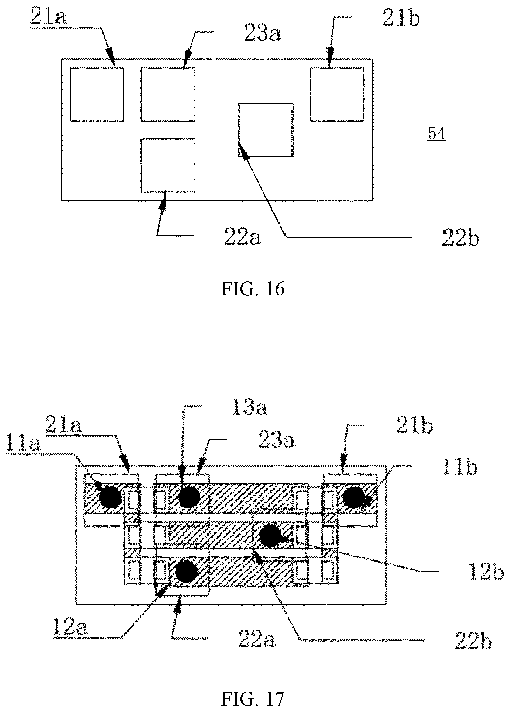

FIG. 14 is a schematic diagram showing wiring of the first circuit layer 52 of the two-in-one light-emitting module of another embodiment of the present application. As shown in FIG. 14, the two-in-one light-emitting module has two light-emitting units, and each light-emitting unit includes three light-emitting chips 512, i.e., RGB. A total of six light-emitting chips 512 are provided. The first circuit layer 52 includes two common terminals (11a, 11b), a metal wire (13a) for two blue-light chips, a metal wire (12b) for two green-light chips, and a metal wire (12a) for two red-light chips. FIG. 15 is a schematic diagram of the via circuit layer 53 of the two-in-one light-emitting module in the embodiment of FIG. 14. The black dots represent the pad leads in the vias, surrounded by insulating material. FIG. 16 is a schematic diagram of the pad layer 54 of the two-in-one light-emitting module in the embodiment of FIG. 15, which has five pads (21a, 23a, 21b, 22b, 22a).

FIG. 17 is a schematic diagram of a lamination of the first circuit layer 52, the via circuit layer 53, and the pad layer 54 in FIGS. 14-16. As shown in FIG. 17, the common terminals (11a, 11b) of the first circuit layer 52 can be connected to two pads (21a, 21b) of the pad layer 54 through the pad leads of the via circuit layer 53. The metal wire (13a) for the two blue-light chips are connected to the pad (23a) of the pad layer 54 through the pad leads of the via circuit layer 53. The metal wire (12b) for the two green-light chips is connected to the pad (22b) of the pad layer 54 through the pad leads of the via circuit layer 53. The metal wire (12a) for the two red-light chips is connected to the pad (22a) of the pad layer 54 through the pad leads of the via circuit layer 53. The circuit principle of this two-in-one light-emitting module can be referred to FIG. 3.

On the other hand, the present application also provides a display formed by splicing a plurality of all-in-one light-emitting modules according to the above-mentioned embodiments. The display has a smaller number of pads, which reduces the difficulty of packaging.

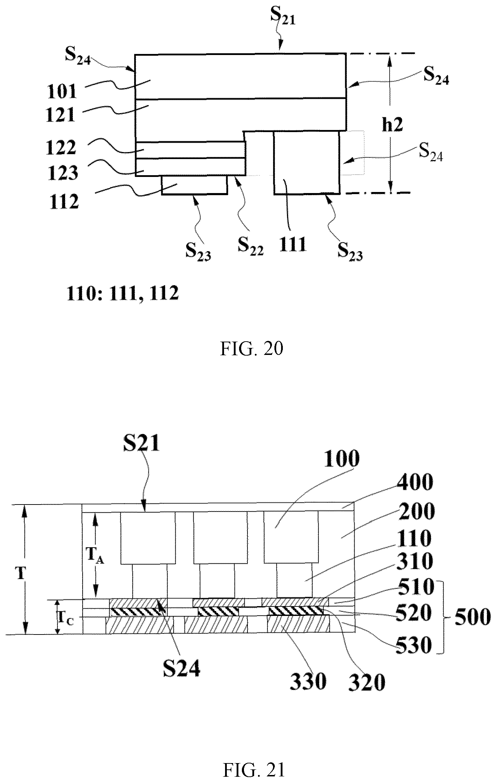

The following embodiment discloses an N-in-one LED package assembly, including N light-emitting units arranged in a Nx×Ny matrix, where N≥3, Nx, Ny are integers and Nx≥Ny. A packaging layer fills the gap between the light-emitting units. A wiring layer is located under the packaging layer and connected to each light-emitting unit, thereby connecting the LED chips in the multiple pixel regions PX in series and/or parallel to constitute an n-in-one pixel region. In the case of RGB display, for example, each such light-emitting unit may include three LED chips 100, each of which typically includes a first electrode and a second electrode located on the same side, such as a horizontal type LED chip or a flip-chip type LED chip, as shown in FIG. 20. The number of horizontal pixels is Nx and the number of vertical pixels is Ny, i.e., arranged in Ny columns and Ny rows. Preferably, N is an integer multiple of a natural number below 5, Nx is greater than or equal to 3, and 1≤Nx/Ny≤5. The ratio of Nx and Ny is maintained within the range, which makes it easy to achieve a package assembly with a minimum number of pads through the wiring layer, and maintains a better aspect ratio to facilitate subsequent placement of chips at the application end.

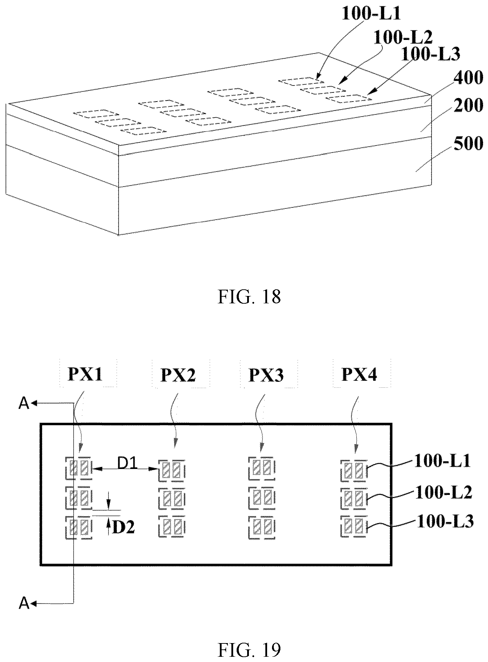

In an embodiment, N=2^{2×k}, for example, the assembly may be four-in-one, sixteen-in-one or sixty-four-in-one, when the ratio of Nx to Ny is preferably 4:1. Such an arrangement of LED chips, together with the wiring layer, can achieve a minimum number of pads. FIG. 18-19 disclose a four-in-one LED package assembly, including a 4× 1 matrix arrangement of four light-emitting units. Each light-emitting unit includes a number of LED chips of different wavelengths, preferably, for example, at least three LED chips emitting red light (R), green light (G), and blue light (B). The assembly may further include a LED chip emitting white light (including a wavelength conversion layer), that is, a combination of RGBW is formed, so that the brightness of the display can be enhanced, which is very beneficial to outdoor display.

Each light-emitting unit is equivalent to a pixel region PX, which may also be referred to as a pixel. Referring to FIG. 21 which is a schematic sectional view along line AA in FIG. 19. Each pixel region PX has a plurality of LED chips 100 spaced apart from one another and having a light-emitting surface S21. The package assembly further includes a packaging layer 200 which holds the LED chips and which is filled in the gap between the LED chips, and a multi-layer wiring layer 310-330 covering the packaging layer 200. The multi-layer wiring layer includes a first wiring layer 310, a via layer 320, and a second wiring layer 330, and each wiring layer is electrically isolated through an insulating layer 500. The first wiring layer 310 is formed on the lower surface of the plurality of LED chips to connect a plurality of LED chips in parallel and/or in series. The via layer 320 is formed on the first wiring layer and forms electrical connection with the first wiring layer 310. The second wiring layer 330 is formed on the via layer and forms an electrical connection with the via layer 320.

Referring to FIG. 20 showing one of the above LED chips 100L1-100L3, each of the above LED chips 100L1-100L3 has a pair of electrodes 110 located on the same side, a first surface S21 and a second surface S22 opposite to each other, and a side surface S24 connected between the first surface S21 and the second surface S22. The first surface S21 is the light-emitting surface S21, and the second surface S22 is provided with the pair of electrodes 110. Further, the LED chip includes a substrate 101, a first type semiconductor layer 121, a light-emitting layer 122 and a second type semiconductor layer 123. The first type semiconductor layer 121 and the second type semiconductor layer 123 may be p-type semiconductor layer and n-type semiconductor layer, respectively. The LED chip electrode set 110 includes a first electrode 111 electrically connected to the first type of semiconductor layer 121, and a second electrode 112 electrically connected to the second type of semiconductor layer 123. In some other embodiments, each LED chip electrode set 110 also includes thickened layers made of conductive material. These thickened layers are provided between the first electrode 111 and the first wiring layer, and between the second electrode 112 and the first wiring layer 310, respectively, and can be formed by electroplating, chemical plating or printing, etc. The material can be Cu, CuₓW or other conductive metal materials. By increasing the thickness of the electrodes, the contact area between the side S24 of the LED chip and the packaging layer 200 can be increased, thus increasing the adhesion between the LED chip and the packaging layer 200. Preferably, the thickness of the electrode set of each LED chip is 5~500 µm, which can be, for example, 30 µm to 100 µm, 30 µm to 50 µm, or 80 µm to 120 µm, depending on the specific needs. The LED chip 1100 can be an LED chip with a conventional size (generally refers to the chip size of more than 200 µm on one side), or Mini LED chip (generally refers to the chip size between 100-200 µm), or Micro LED chip (generally refers to the chip size of no more than 100 µm). In this embodiment a Mini LED chip or micro LED chip is preferable.

Referring again to FIG. 21, first packaging layer 200 is filled around the plurality of first, second, and third LED chips 100L1-100L3. Preferably, the packaging layer 200 has a light transmittance of less than 30%. More preferably, the packaging layer 200 has a light transmittance of 5%~20%. Optionally, the packaging layer 200 is opaque and nontransparent. Specifically, it includes light-absorbing component (not shown in the figures). The light-absorbing component is provided at least around the side walls of the LED chips or between adjacent LED chips, or further at least around the LED semiconductor light-emitting stacked layers or between adjacent semiconductor light-emitting stacked layers. The light-absorbing component may specifically be light-absorbing particles dispersed within the epoxy resin or silicone used in the packaging layer, such as black particles, toner. Alternatively, the light-absorbing component may be a black resin. The light-absorbing component of the packaging layer 200 is provided at least around the LED sidewalls to prevent light-emitting form the side of the LED chips, thereby the emitting light of the LED chip is mainly concentrated or all concentrated at the light-emitting side, reducing light crosstalk or mixing between light from different LED chips in the side direction. In a specific embodiment, the packaging layer 200 may be epoxy resin or silicone with black colorant, so that all areas of the entire LED packaging assembly are black, except the light-emitting surface S21 of the LED chips 100, which helps to improve the contrast of the display panel. At the same time, each LED chip 100 is isolated through the black packaging material to reduce the light interference between individual LED chips. In some embodiments, the hardness of the packaging layer 200 is preferably D60 or above, more preferably, D85 or more.

Further, a transparent or translucent material layer is formed on the packaging layer 200 as another packaging layer 400, which covers the first surface S21 of the plurality of first, second, and third LED chips, preventing the LED chips from being exposed. The packaging layer 400 can be used as a light scattering lens to produce a light scattering effect. When the final LED packaging assembly is used in the display panel, it can effectively reduce the dizziness. Further, the illustrated packaging layer 40 can include a light scattering material, such as scattering g particles. The thickness of the packaging layer 400 is preferably between 5~20 µm, such as 10 µm, which, on the one hand, can protect the light-emitting surface of the LED chips, and on the other hand, with the packaging layer 200 using light-absorbing material, can reduce the light interference between individual LED chips. The light transmittance is preferably 40% or more. In some embodiments, the LED package assembly is used for indoor display, in which, the package layer 400 is preferably a translucent layer with a light transmittance of preferably 40% to 80%, more preferably 70 to 80%, which can reduce the brightness of the LED chip and thereby reduce light dizziness. In some embodiments, the package assembly is used in an outdoor display, in which, the package layer 400 is preferably a transparent layer with a light transmittance of preferably 80% or more, more preferably 80%.

In this embodiment, the plurality of first, second, and third LED chips 100L1-100L3 may first be temporarily adhered to a support such as a tape with the light-emitting surface S21 of the LED chips 100 as a die-bonding surface, when the electrode surface S24 is facing upward, and then a fluid insulating material is filled between the chips and cured to form the packaging layer 200. In this embodiment, it is preferable to control the thickness of the adhesive material of the tape between 5~20 µm, which on the one hand ensures that the LED chips will not be displaced when filling the packaging layer, and on the other hand ensures that the first surface S21 of the first, second and third LED chips 100L1-100L3 are substantially located at the same level with a height difference substantially below 10 µm, which facilitates the formation of a uniform light-emitting surface and reduces light interference between sidewalls when significantly increasing the pixel regions of the package assembly.

Referring again to FIG. 19, the first, second and third chips LED 100L1-100L3 in each pixel region PX of the package assembly are arranged in a straight line. Specifically, individual LED chips of each light-emitting unit are arranged in a row in a first direction Y, and the first and second electrodes of each LED chip are arranged side by side in a second direction X, where the first and second directions are substantially perpendicular, so as to facilitate the wiring at the application end, thereby reducing the pitch between the chips. Each pixel region is considered as a pixel, and the dot pitch D1 for each pixel is preferably 1mm, more preferably, 0.8mm or less, for example, 0.3-0.5 mm, or 0.5-0.8 mm. The pitch D2 between chips in the same pixel region PX is preferably 100 µm or less, for example, 50~100 µm, or 50 µm or less. In some display panel applications, the pitch between LED chips in the same pixel region is preferably 50 µm or less, such as 40~50 µm, or 30~40 µm, or 20~30 µm, or 10~20 µm. The smaller the pitch, the better it is to reduce the size of this LED package assembly, which thus improves the resolution of the display panel. In some other embodiments, N may be 16, 64, or others, and the pitch D1 between individual pixels can reach less than 0.3mm, for example, 0.2mm, or 0.1mm.

Referring again to FIG. 21, the multi-layer wiring layer is formed on the second surface of the plurality of LED chips and specifically includes a first wiring layer 310, a via layer 320, and a second wiring layer 330. The first wiring layer 310 is connected to the electrodes 110 of the LED chips, the via layer 320 is formed on the first wiring layer 310, and the second wiring layer 330 is formed on the via layer 320 and is electrically connected to the first wiring layer 310 through the via layer 320. The multi-layer wiring layer is preferably made of a metal material with a melting point higher than 400°C, such as Ag, Cu, Ni, Al, etc. The material of each layer may be the same or different, and may be formed by electroplating, chemical plating or printing, etc. The thickness of each layer is preferably 100 µm or less. Specifically, the first wiring layer 310 is formed on the surface of the package layer 200 and forms an electrical connection with the electrodes 110 of the plurality of LED chips. An insulating layer 510 is filled in the gap between the wires of the first wiring layer 310, exposing a surface of the first wiring layer 310 away from the LED chips. The material of the insulating layer 510 can be the same as the material of the packaging layer 200, or different. When the same material is used, the insulating layer 510 and the packaging layer 200 form a single layer, and it is difficult to distinguish the two. In an embodiment, for example, the LED package assembly is used in a display device, and the insulating layer 510 and the packaging layer 200 are both epoxy resin or silicone with colorant. Specifically, the insulating layer 510 and the packaging layer 200 are both epoxy resin or silicone with colorant. In some embodiments, the hardness of the insulating layer 510 is not less than the hardness of the first wiring layer 310, for example, D60 or above, more preferably, D85 or above, which helps to expose the surface S310 of the first wiring layer 310 by grinding.

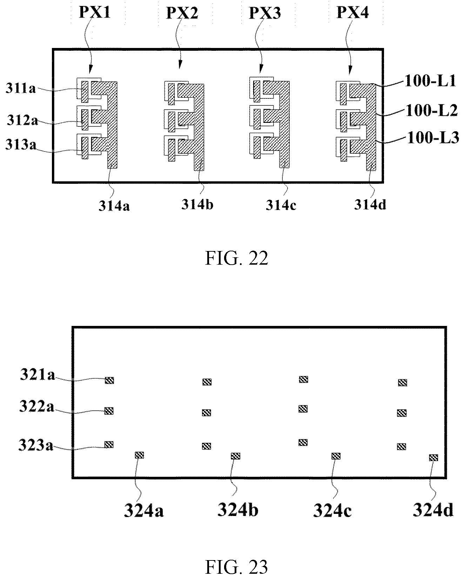

Referring to FIGS. 22 to 24, patterns of the first wiring layer, the via layer, and the second wiring layer in a specific embodiment are shown. The first wiring layer 310 includes common lines 314a-d that connect the second electrodes of the first, second, and third LED chips located in the same column, respectively, in parallel. Further, the first wiring layer includes first lines 311a~313a, of which, 311a is connected to the first electrode of the first LED chip 100-L1, 312a is connected to the first electrode of the second LED chip 100-L2, and 313a is connected to the first electrode of the third LED chip 100-L3. The via layer 320 is located on the surface S310 of the first wiring layer 310, including a series of vias 321a~323a, 324a~324d formed in an insulating layer 520. The number and location of the vias correspond to the individual wires of the first wiring layer, where the pattern marked with solid slash in FIG. 23 represent the vias. The material of the insulating layer 520 can be referred to the insulating layer 510. The thickness of the via layer is usually less than 100 µm. In some embodiments that the package assembly has a thinner structure, the thickness of the via layer is preferably 20~50 µm, for example, 25~30 µm, so as to avoid excessive stress and thermal resistance due to the large thickness of the via layer, and reduce the total thickness of the package structure, while ensuring the strength of the package structure, making the application products thinner and lighter. In other embodiments, the via layer has a thickness of 50~80 µm, for example 60 µm, thus appropriately increasing the thickness of the package assembly and thus facilitating pickup from the sidewalls of the devices. The second wiring layer 330 is located on the via layer 320 and forms an electrical connection with the first wiring layer 310 through the respective vias of the via layer 320. The second wiring layer 330 includes connecting wires 331~333 and connecting portions 331a~333a, 334a~334d. The connecting wire 331 connects the first electrodes of the first LED chips located in the same row, the connecting wire 332 connects the first electrodes of the second LED chips located in the same row, the connecting wire 333 connects the first electrodes of the third LED chips located in the same row. The series of the connection portions can be used as electrode pads for the package assembly to connect to a power supply. In a preferred embodiment, pads can be made in the corresponding area of the connection portion, and the area outside the pads can be covered with ink, epoxy resin or other insulating material to protect the lines of the second wiring layer. The gap between the lines of the third wiring layer 330 is filled with an insulating layer 530, and the surface of the second wiring layer 330 away from the LED chip is exposed. The material of the insulating layer 530 can be designed with reference to the insulating layer 510. In a specific embodiment, the connection portions of the second wiring layer 330 completely covers each via of the via layer 320, increasing the contact area between the second wiring layer and the vias. In addition, in process, conductive material of the via layer and the second wiring layer can be formed in the same process, saving a process of forming conductive material and grinding, which can effectively save costs and improve product stability.

The insulating layers 510 to 530 may be of the same material or of different materials, specifically epoxy resin, silicone, polyimide, benzocyclobutene, or PBO. When composed of the same material, the insulating layers 510-530 are combined into a single layer 500, which is difficult to distinguish them. In some specific embodiments, the insulating layers 510-530 are made of opaque or low-transmittance materials, such as epoxy resin or silicone doped with a black colorant, preventing or reducing the light emitted from the LED chips from a rewiring layer which may otherwise cause interference. When an opaque or low-transmittance material is used as the insulating layer, a metal wire pattern in the wiring layer can be formed first, then the insulating layer can be filled, and finally the surface of the metal wires in the wiring layer can be exposed by grinding. In other embodiments, when the packaging layer 200 is made of a material with low light transmittance or no light transmission, the insulating layers 510-530 may be partially or fully light transmissive, and the transmittance is higher than the that of the packaging layer 200. The light-transmissive layer can be made without adding colorants or light-absorbing materials, such as toner or dyes, and is preferably a silicone or epoxy resin material layer that does not contain micron-sized particles (usually particles with a diameter of 1 micron or more, such as C-powder particles), which can ensure the reliability of the encapsulation of the insulating layer to the wiring layer. In other embodiments, a photosensitive material is cured to form the insulating layer, which simplifies the process. Meanwhile, the area around the chip and the non-metallic part of the electrode surface are covered with light-absorbing material as the packaging layer 200 to prevent interference of light from the sides of the chips.

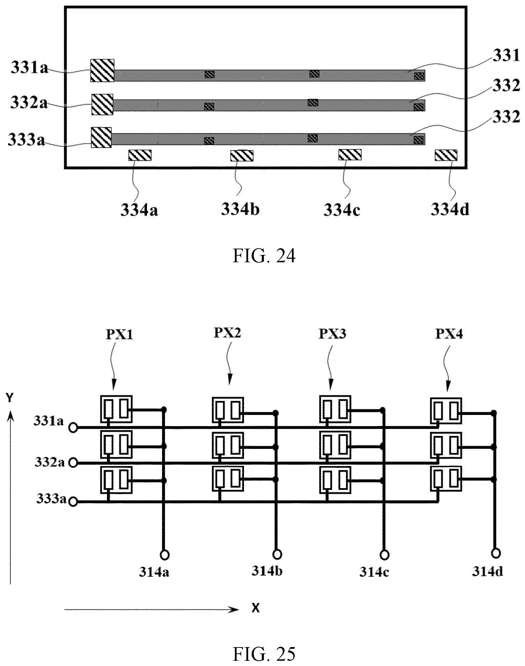

FIG. 25 illustrates the circuit connections for the four-in-one light-emitting units. In this embodiment, first of all, in LED chip arrangement, the LED chips in each PX are arranged in a straight line. Specifically, respective LED chips of each light-emitting unit are arranged in a column in a first direction Y. The first and second electrodes of each LED chip are arranged side by side in a second direction. The first and second directions are substantially perpendicular. The wiring layer connects the first electrodes of the first, second and third LED chips located in the same column in parallel in the first direction Y, and connects the second electrodes of the first, second and third LED chips of two or more light-emitting units located in the same row in parallel in the second direction X, thus electrically connecting the plurality of light-emitting units to form an all-in-one light-emitting module. Unlike the package assembly arranged in a 2×2 matrix, in this embodiment, Nx/Ny is equal to 4:1, which has a better aspect ratio for easy placement of chips at the application end, and the first electrodes of the same type of LED chips are connected in parallel in the lateral direction (X-axis direction), which can minimize the number of pads for external connection.

In some other embodiments, N may be 16 or 64, etc. When N is 16, Nx could be 8 and Ny is preferably 2. The arrangement of the chips inside each light-emitting unit can be shown with reference to FIG. 19.

Referring again to FIG. 21, the package assembly according to the above exemplary embodiment does not have a package substrate or holder for carrying the LED chips, and the Nx×Xy matrix arrangement of light-emitting units is mainly fixed and supported by insulating material layers (including 200, 400 and 500) and wiring layers. The thickness T of the package assembly depends mainly on the thickness T_{A} of the LED chips and the thickness Tc of the wiring layers. In some specific embodiments, mini-type LED chips are used which have a thickness T_{A} between 40~150 µm. The thickness Tc of the multi-layer wiring layer is between 20~200 µm, and more preferably, the thickness Tc of the wiring layer is between 50~150 µm. T and T_{A} meet the relation: 1.4≤T/T_{A}≤10. In this way, the circuit layer can avoid too much stress and too much thermal resistance, and make the total thickness of the package assembly smaller while ensuring the strength of the package structure body. For example, in an embodiment, the thickness of the LED chip T_{A} is approximately 80 µm, the thickness of the package assembly can be 120-500 µm, for example, 120-200 µm, and in this case, the thickness of each sub-layer of the wiring layer can be 20~50 µm, ratio 30 µm. For example, in another embodiment, when the size of the package assembly is small (for example, 0.4mm×0.4mm or smaller), it is inconvenient to grab the package assembly from an upper surface thereof. In this case, the thickness T of the package assembly can be increased appropriately so that the side wall of the package assembly has a larger area for a pickup device to contact and grasp, and preferably, the thickness of the package assembly can be 320-500 µm, such as 340-360 µm. The thickness of the package assembly can be increased by increasing the thickness of the LED chip and/or the thickness of the wiring layer. For example, the thickness of the electrodes of the LED chips can be increased, and the thickness of each wiring layer can be appropriately increased, in which case, the thickness of the via layer is preferably 30~80 µm, and the thickness of other wiring layers is preferably 50~100 µm. In some specific embodiments, a micro-type LED chip is used, the thickness of the chip T_{A} is 5~10 µm, and the thickness of the multi-layer wiring layer Tc is 20~200 µm. More preferably, the thickness of the wiring layer Tc is 50~150 µm. T and T_{A} meet the relation: 10≤T/T_{A}≤60, for example, the thickness of the package assembly can be 50~100 µm, or 100-200 µm.

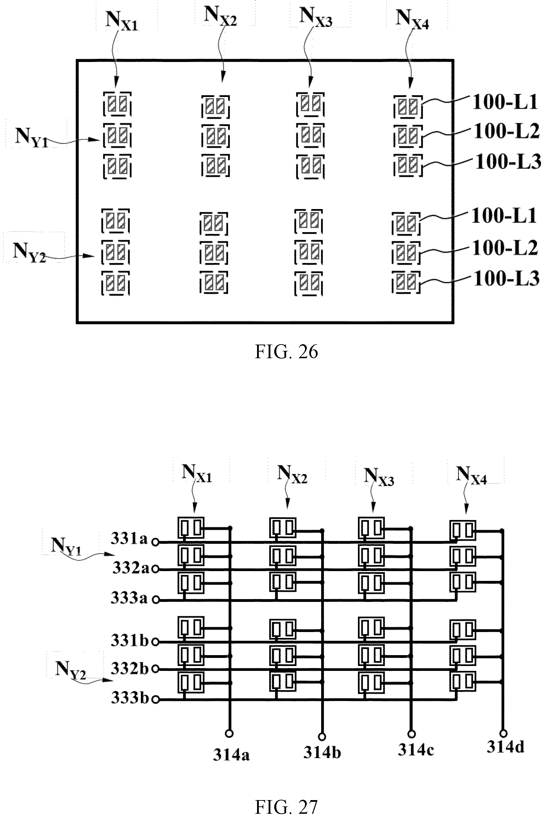

FIGS. 26-27 show another embodiment of the LED package assembly of the present invention. Referring to FIGS. 26 and 27, the package assembly includes eight pixel regions arranged in a 4×2 matrix, i.e., including four columns N_{X1}-N_{X4} and two rows of light-emitting units N_{Y1}-N_{Y2}. Wires 314a~314d of the wiring layer connect the second electrodes of all LED chips located in the same column from the first direction. For example, the wire 314a connects the second electrodes of all LED chips in the Nxi column. Wires 331a~333a, 331b~333b of the wiring layer connect the first electrodes of LED chips of same types located in the same row. For example, 331 connect the first LED chips located in the N_{Y1}. In this embodiment, by this design, the number of pads of the package assembly P= Nx+Ny×3 i.e., 10, which reaches the minimum number of pads.

The above LED package assembly uses this package layer to fix and package the pixel dots arranged in a matrix, and a multi-layer wiring layer is provided to connect the LED chips of pixels in series. As a result, the above LED package assembly does not require a circuit board with soldering and precise wiring, improving reliability and contrast. In addition, the electrode set of the LED chip does not need to be soldered with solder paste on the circuit board, avoiding the problem of poor chip soldering and improving the integration of LED and electronic components, so it can indeed achieve the object of the invention.

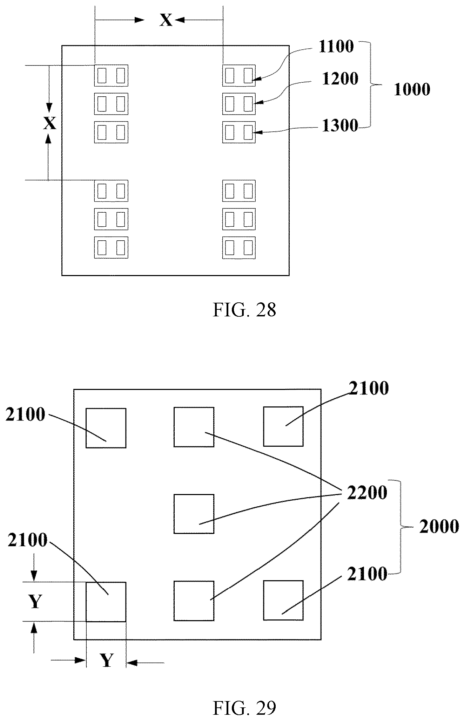

FIGS. 28 and 29 show another embodiment of the LED package assembly of the present invention. Referring to FIG. 28, this embodiment provides an N-in-one package including N light-emitting units 1000, N being an integer greater than one, less than or equal to 64, and sqrt(N) being an integer greater than one. In either of the length direction and width direction of the package, the number of light-emitting units 1000 is equal to sqrt(N). Each light-emitting unit 1000 includes one red-light chip 1100, one blue-light chip 12000 and one green-light chip 1300. A pitch between any two adjacent the chips of the same wavelength is defined as X. The package length and width are both equal to X ^{∗} sqrt (N). Electrode pads 2000 and N light-emitting units 1000 are electrically connected. The total number of electrode pads 2000 is within the range of a rounded-up integer of 2^{∗}sqrt (3N)±1. In any one of the length direction and width direction of the outmost of the package, the number of electrode pads 2000 is within the range of a rounded-up integer of sqrt [2^{∗}sqrt (3N)] to a rounded-down integer of sqrt [2^{∗}sqrt (3N)]. In at least one of the length direction and width direction of the outmost of the package, the number of electrode pads 2000 is equal to a rounded-up integer of sqrt [2^{∗}sqrt (3N)], and in the direction that the number of electrode pads 2000 is equal to a rounded-up integer of sqrt [2^{∗}sqrt (3N)], the sizes of the electrode pads 2000 are equal to the spacing between two adjacent electrode pads 2000. Defining the length and the width of the electrode pads 2000 as Y, the length and width of the package are both approximately equal to 2^{∗}sqrt [2^{∗}sqrt(3N)]^{∗}Y, and so the package meets the relation X≥{0.2^{∗}sqrt[2^{∗}sqrt(3N)]}/sqrt(N).

It should be noted that a light-emitting unit 1000 is a pixel. 3 chips of different wavelengths in each light-emitting unit 1000 are arranged in the same order, and the pitch of any two adjacent chips of the same wavelength is the dot pitch.

It should be noted that since the length and width of the package described by dot pitch X are equal to X^{∗}sqrt (N), the length and width of the package described by the size Y of electrode pads 2000 are approximately equal to 2^{∗}sqrt [2^{∗}sqrt (3N)]^{∗}Y, and thus it is known that X^{∗}sqrt (N) ≈ 2^{∗}sqrt [2^{∗} sqrt (3N)]^{∗}Y, from which it can be deduced that [X^{∗} sqrt (N)]/{2^{∗}sqrt [2^{∗}sqrt (3N)]} ≈ Y. If it is required to ensure heat dissipation effect of the package, avoid the risk of short circuit, and facilitate placement of chips at the application end, the length and width of the electrode pads 2000 are required to be greater than or equal to 0.1mm, i.e., Y≥0.1mm. Therefore, according to the relation Y ≈ [X^{∗}sqrt (N)]/{2^{∗}sqrt[2^{∗}sqrt (3N)]}≥0.1mm, the relation between the dot pitch X and the number of pixels N can be derived as: X≥{0.2^{∗}sqrt[2^{∗}sqrt (3N)]}/sqrt (N). The value of the dot pitch is known in actual applications, therefore, on the basis of the relation X≥{0.2^{∗}sqrt [2^{∗}sqrt (3N)]}/sqrt (N), the most suitable number N of pixels for the package of the present application can be set to ensure that the length and width of the electrode pads 2000 of the package are greater than or equal to 0.1mm, which can meet the high-density demand of the small-pitch LED package and provides the package with sufficient heat dissipation capacity, so as to effectively guarantee the reliability of the product, effectively avoid the risk of short circuit, and facilitate the placement of chips at the application end.

It is to be noted that the total number of electrode pads 2000 and the number in a single direction (length direction or width direction) of the outermost of the package can be set with reference to the following table.

**Table 1: Setting of the total number of electrode pads 2000**

| N | 2^{∗}sqrt(3N) | Rounded-up integer | Rounded-down integer |
|---|---|---|---|
| 4 | 6.92820323 | 7 | 7 |
| 9 | 10.39230485 | 11 | 12 |
| 16 | 13.85640646 | 14 | 14 |
| 36 | 20.78460969 | 21 | 21 |
| 64 | 27.71281292 | 28 | 28 |

**Table 2: Setting of the number of electrode pads 2000 in a single direction of the outermost of the package**

| N | sqrt [2^{∗}sqrt(3N)] | Rounded-up integer | Rounded-down integer | Number of electrode pads in the X direction of the outermost of the package | Number of electrode pads in the Y direction of the outermost of the package |
|---|---|---|---|---|---|
| 4 | 2.632148026 | 3 | 2 | 3 | 2 |
| 9 | 3.223709795 | 4 | 3 | 3 | 4 |
| 16 | 3.722419436 | 4 | 3 | 4 | 4 |
| 36 | 4.559014114 | 5 | 4 | 5 | 5 |
| 64 | 5.264296052 | 6 | 5 | 5 | 6 |

Note: X-direction and Y-direction in Table 2 correspond to the length direction and width direction, or width direction and length direction of the outermost of the package, respectively.

It is to be noted that, when the number of electrode pads 2000 body is within the range of a rounded-up integer of sqrt [2^{∗}sqrt(3N)] to a rounded-down integer of sqrt [2^{∗}sqrt(3N)] in any of the length direction and width direction of the outermost of the package, and the number of the electrode pads is equal to the rounded-up integer of sqrt [2^{∗}sqrt(3N)] in at least one of the length direction and width direction of the outermost of the package, the number of electrode pads 2000 in any of the length and width directions of the package is less than or equal to the rounded-up integer of sqrt [2^{∗}sqrt(3N)]. Therefore, the spacing between two adjacent electrode pads 2000 in any of the length and width directions of the package is greater than or equal to the size of electrode pad 2000, so the length and width of electrode pads 2000 are naturally guaranteed to be greater than or equal to 0.1mm.

As an example, the length and width of the electrode pads 2000 are equal, both greater than or equal to 0.1mm.

As an example, the spacing between two adjacent electrode pads 2000 is greater than or equal to 0.1 mm in either of the length direction and width direction of the package.

As an example, when the number of electrode pads 2000 in both the length direction and the width direction of the outermost part of the package is equal to rounded-up integer of sqrt [2^{∗}sqrt(3N)], the spacing between two adjacent electrode pads 2000 in the length direction of the outermost part of the package is equal to the spacing between two adjacent electrode pads 2000 in the width direction of the outermost part of the package.

As an example, when the number of electrode pads 2000 in the length direction and the width direction of the package outermost is equal to a rounded-up integer of sqrt [2^{∗}sqrt (3N)] and a rounded-down integer of sqrt [2^{∗}sqrt (3N)], respectively, the spacing between two adjacent electrode pads 2000 in the direction that the number of electrode pads 2000 is equal to a rounded-down integer of sqrt [2^{∗}sqrt (3N)] is greater than the spacing between two adjacent electrode pads 2000 in the direction that the number of electrode pads 2000 is equal to a rounded-up integer of sqrt [2^{∗}sqrt (3N)].

As an example, the length and the width of the package are equal.

As an example, the number of light-emitting units 1000 in the length direction of the package is equal to the number of light-emitting units 1000 in the width direction of the package.

As an example, the electrode pads 2000 include first electrode pads 2100 and second electrode pads 2200, each chip within each light-emitting unit 1000 is electrically connected to a first electrode pad 2100 and a second electrode pad 2200, and the chips of different wavelengths are electrically connected to different combinations of the first electrode pad 2100 and the second electrode pad 2200.

It is noted that the first electrode pads 2100 are of opposite polarity to the second electrode pads 2200.

As an example, the number of first electrode pads 2100 is the same as the number of light-emitting units 1000, and the N common terminals of N light-emitting units 1000 are electrically connected to the N first electrode pads 2100 in one to one correspondence.

As an implementation of this embodiment, as shown in FIG. 28 which is a schematic diagram of the structure of the package when the number N of light-emitting units 1000 is equal to four, the package has a total of 12 chips, to which seven electrode pads 2000 are electrically connected. Four of the pads are the first electrode pads 2100, corresponding to the 4 light-emitting units 1000.

The N-in-1 package in this embodiment has the most suitable number of pixels when the dot pitch is determined, which not only ensures the required high density of the small-pitch LED package, but also effectively solves the problems of poor heat dissipation, easy short-circuiting, and difficult placement of chips at the application end of small-pitch LEDs because the length and width of its electrode pads are greater than or equal to 0.1 mm, which is of great importance to the marketing of small pitch LEDs.

The present embodiment provides a display including a plurality of N-in-1 packages described in the embodiment I.

As an example, the ratio of diagonal, length and width of the display is 18.36:16:9.

In summary, the present invention provides an N-in-one package, including N light-emitting units and electrode pads electrically connected thereto. Each light-emitting unit includes one red-light chip, one blue-light chip, and one green-light chip. The pitch X between any two adjacent the chips of the same wavelength and the number N of the light-emitting units meet X≥{0.2^{∗}sqrt[2^{∗}sqrt(3N)]}/sqrt(N). On the basis of the above relation, the most suitable number N of the light-emitting units can be selected when any two adjacent the chips of the same wavelength have a certain pitch X therebetween, so as to ensure that the length and width of the electrode pads of the package are greater than or equal to 0.1mm, which can meet the high-density demand of the small-pitch LED package and also provides the package with sufficient heat dissipation capacity, thereby effectively guaranteeing the reliability of the product, effectively avoiding the risk of short circuit, and facilitating the placement of chip at the application end. The present invention also provides a display including a plurality of the N-in-one packages provided by the present invention. Therefore, the present invention effectively overcomes the shortcomings of the prior art and has a high industrial value.

However, the above mentioned are only embodiments of the present invention, and cannot be used to limit the scope of the of the present invention. All the simple equivalent changes and modifications made in accordance with the scope of the patent application and the patent specification of the present invention are still within the scope of the coverage of the present invention.

## Claims

1. An all-in-one light-emitting module, **characterized in that** it comprises :
a number N of light-emitting units, N being an integer greater than one; and
a number a of first electrode pads and a number b of second electrode pads connected to the N light-emitting units, the first electrode pads and the second electrode pads being of opposite polarity;
each light-emitting unit comprises a number n of light-emitting chips, n being an integer greater than or equal to 3, each light-emitting chip is connected to a first electrode pad and a second electrode pad, and different light-emitting chips are connected to different combinations of the first electrode pad and the second electrode pad wherein the numbers N, n, P and Q satisfy an equation of a×b = n×N, a and b being each an integer greater than or equal to one.

2. The all-in-one light-emitting module of claim 1, **characterized in that** the number of first electrode pads is the same as the number of the light-emitting units, and N common terminals of the N light-emitting units are connected to N first electrode pads in one to one correspondence.

3. The all-in-one light-emitting module of claim 2, **characterized in that** each light-emitting unit comprises a red-light chip, a green-light chip and a blue-light chip, the red-light chips of all light-emitting units are connected to a first one of the second electrode pads, the green-light chips of all light-emitting units are connected to a second one of the second electrode pads, and the blue-light chips of all light-emitting units are connected to a third one of the second electrode pads.

4. The all-in-one light-emitting module of claim 3, **characterized in that** each light-emitting unit further comprises a white light chip, and the white light chips of all light-emitting units are connected to a fourth one of the second electrode pads.

5. The all-in-one light-emitting module of claim 2, **characterized in that** the number of the light-emitting units is four, the number of the first electrode pads is four, and the common terminals of the four light-emitting units are connected to the four first electrode pads in one to one correspondence.

6. The all-in-one light-emitting module of claim 2, **characterized in that** the number of the light-emitting units is two, the number of the first electrode pads is two, and the common terminals of the two the light-emitting units are connected to the two first electrode pads in one to one correspondence.

7. The all-in-one light-emitting module of claim 1, **characterized in that** the number of the first electrode pad is one, N common terminals of the N light-emitting units are connected to the common first electrode pad, each light-emitting chip is connected to a respective one of the second electrode pads, and the number of the second electrode pads is the product of n and N.

8. The all-in-one light-emitting module of claim 7, **characterized in that** each light-emitting unit comprises three kinds of light-emitting chips which include a red-light chip, a green-light chip and a blue-light chip, and the number of the second electrode pads is 3×N.

9. The all-in-one light-emitting module of claim 7, **characterized in that** each light-emitting unit includes four kinds of light-emitting chips which include a red-light chip, a green-light chip, a blue-light chip and a white light chip, and the number of the second electrode pads is 4×N.

10. The all-in-one light-emitting module of claim 1, **characterized by** further comprising a light-shielding material wrapped around sides of the light-emitting chips and exposing electrodes of the light-emitting chips, the light-shielding material and all light-emitting chips forming a light-emitting layer of the light-emitting module.

11. The all-in-one light-emitting module of claim 10, **characterized by** further comprising a first circuit layer, a via circuit layer and a pad layer provided sequentially under the light-emitting layer,
the first circuit layer comprises a first insulating layer affixed to the light-emitting layer and a metal wiring layer embedded within the first insulating layer and connecting the electrodes of the light-emitting chip,
the via circuit layer comprises a second insulating layer affixed to the first insulating layer and having vias, a pad lead layer provided within the vias and connecting the metal wiring layer; and
the pad layer is provided with the first electrode pads and the second electrode pads, the first electrode pads and the second electrode pads being connected to the metal wiring layer via the pad lead layer.

12. The all-in-one light-emitting module of claim 11, **characterized in that** the pad layer further comprises:
electrode wires connecting the pad lead layer to the first electrode pads, or connecting the pad lead layer to the second electrode pads.

13. The all-in-one light-emitting module of claim 12, **characterized in that** the pad layer further comprises a third insulating layer filled around the first electrode pads, the second electrode pads and the electrode wires.

14. The all-in-one light-emitting module of claim 13, **characterized in that** the first insulating layer, the second insulating layer or the third insulating layer is of black insulating material.

15. A display, **characterized by** being formed by splicing a plurality of all-in-one light-emitting modules as claimed in any one of claims 1-14.

16. A light-emitting diode package assembly, **characterized by** comprising:
N light-emitting units arranged in a Nx×Ny matrix, wherein Nx and Ny are integers, Nx≥Ny, and N≥3,each light-emitting unit comprising a LED chips each comprising a first electrode and a second electrode located on a same side;
an packaging layer filling gaps between the LED chips and covering side walls of the LED chips;
a wiring layer, formed on a second surface of the plurality of LED chips and electrically connecting the plurality of light-emitting units to form an N-in-one light-emitting module; and
pads, formed on the wiring layer, the number of the pads P being equal to Nx+Ny×a.

17. The light-emitting diode package assembly of claim 16, **characterized in that** the N light-emitting units are arranged in Nx rows and Ny columns, which minimizes the number P of the pads.

18. The light-emitting diode package assembly of claim 16, **characterized in that** Nx>Ny.

19. The light-emitting diode package assembly of claim 16, **characterized in that** the a LED chips of each light-emitting unit is arranged in a column in a first direction Nx, and the first electrode and the second electrode of each LED chip are arranged side by side in a second direction Ny.

20. The light-emitting diode package assembly of claim 16, **characterized in that** 1≤Nx/Ny≤5.

21. The light-emitting diode package assembly of claim 16, **characterized in that** when the N is equal to 2^{2×k}, Nx:Ny is equal to 4:1, where k is a natural number.

22. The light-emitting diode package assembly of claim 16, **characterized in that** when the N is equal to 3^{2×k+1}, Nx:Ny is equal to 3:1, where k is an integer greater than or equal to zero.

23. The light-emitting diode package assembly of claim 16, **characterized in that** a pitch between adjacent light-emitting units is 0.8 mm or less.

24. The light-emitting diode package assembly of claim 16, **characterized in that** a first wiring layer electrically connects the first electrodes of the LED chips of same type located in the same row from the first direction, and electrically connects the second electrodes of the LED chips located in the same column from the second direction Ny.

25. The light-emitting diode package assembly of claim 16, **characterized in that** the wiring layer comprises a first wiring layer, a via layer and a second wiring layer, wherein the first wiring layer is formed on the second surface of the plurality of LED chips and connected to the first electrodes and second electrodes of the plurality of LED chips, the via layer is formed on the first wiring layer and is electrically connected to the first wiring layer, and the second wiring layer formed on the via layer and is electrically connected to the via layer.

26. The light-emitting diode package assembly of claim 25, **characterized in that** the via layer has a thickness of 20~80 µm.

27. The light-emitting diode package assembly of claim 16, **characterized in that** the package assembly has a total thickness of 100-500 µm.

28. The light-emitting diode package assembly of claim 16, **characterized in that** the package assembly has a total thickness of 120-200 µm or 320-500 µm.

29. The light-emitting diode package assembly of claim 16, **characterized in that** the wiring layer comprises multiple layers of conductive wires electrically isolated from each other, the number of layers of the conductive wires being four or less.

30. The light-emitting diode package assembly of claim 29, **characterized in that** at least one layer of the multiple layers of the conductive wires has a thickness of 50 µm or less.

31. The light-emitting diode package assembly of claim 14, **characterized in that** at least one layer of the multiple layers of the conductive wires has a thickness of 60 µm or less.
